Europäisches Patentamt

European Patent Office

Office européen des brevets

(19)

(11) **EP 1 262 785 A1**

(12) **DEMANDE DE BREVET EUROPEEN**

(43) Date de publication:
**04.12.2002 Bulletin 2002/49**

(51) Int Cl.[7]: **G01R 33/02**

(21) Numéro de dépôt: **02291289.3**

(22) Date de dépôt: **27.05.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **28.05.2001 FR 0107111**

(71) Demandeur: **VALEO VISION**
**93012 Bobigny Cédex (FR)**

(72) Inventeur: **Albou, Pierre**
**93012 Bobigny Cedex (FR)**

(54) **Dispositif de détection de l'état d'un électro-aimant**

(57)    Le dispositif de l'invention permet de détecter l'état électrique d'une bobine d'un électro-aimant (3), non alimentée, pour savoir si l'équipage mobile de l'électro-aimant est bien dans une position attendue.

A cette fin, le dispositif comporte un premier moyen (5) pour injecter une onde sinusoïdale à la bobine (3) et un second moyen pour produire un signal de référence d'état de bobine qui correspond à l'état électrique attendu de la bobine. Les signaux issus de la bobine (3) et du second moyen de simulation d'une référence (6) sont transmis à un moyen de comparaison et d'alarme (7) pour produire une indication d'un état de défaut (26).

**Fig. 1**

EP 1 262 785 A1

**Description**

La présente invention concerne un dispositif de détection de l'état d'un électro-aimant. Elle trouve application particulièrement pour vérifier l'état de fonctionnement d'un projecteur elliptique bi-fonctions.

Dans l'état de la technique, on connaît un genre particulier de projecteur pour l'éclairage d'un véhicule automobile dans lequel les déplacements d'un cache sont commandés par le noyau d'un électro-aimant entre deux positions. A cet effet, l'électroaimant reçoit un premier signal d'activation pour placer le cache dans une première position, puis un second signal d'activation pour faire revenir le cache à sa position d'origine.

Les premier et second signaux d'activation sont déclenchés par le conducteur du véhicule sur lequel le projecteur elliptique bi-fonctions a été installé, selon que le conducteur commande pour ses projecteurs un état ou fonction "code" ou un état ou fonction "route".

Il peut arriver que le cache ayant été placé en position "route", il ne revienne pas en position "code", bien que son électro-aimant ait été placé électriquement à l'état correspondant à la fonction "code".

Il en résulte un disfonctionnement du projecteur qui doit être signalé pour qu'une mesure soit prise pour remédier à ce défaut de fonctionnement.

D'autres applications des électro-aimants, particulièrement celles dans lesquelles un élément mécanique est entraîné dans les deux sens entre au moins deux positions, peuvent subir le même inconvénient, par exemple quand, bien qu'un état de l'électro-aimant ait été commandé, la partie mobile de l'électroaimant n'a pas effectué correctement le changement de position commandée.

La présente invention permet de détecter l'état de l'électroaimant, et particulièrement de détecter qu'une partie mobile de l'électro-aimant ne se trouve pas placée dans une position mécanique souhaitée correspondant à la commande qui lui a été précédemment appliqué.

En effet, la présente invention concerne un dispositif de détection de l'état d'un électro-aimant, l'électro-aimant pouvant prendre au moins deux états sous l'effet d'un signal de commande.

L'invention se caractérise en ce que le dispositif de détection comporte :

- un premier moyen pour produire un premier signal représentatif de l'état instantané de la bobine de l'électro-aimant ;
- un second moyen pour produire un second signal représentatif de l'état dans lequel devrait se trouver la bobine de l'électro-aimant ;
- un troisième moyen pour comparer lesdits premier et second signaux et produire un signal représentatif d'un défaut de l'électro-aimant.

Selon un aspect de l'invention, le premier moyen comporte un générateur de courant connecté par une borne à la tension d'alimentation continue positive fournie par la batterie et par une borne à la masse électrique, dont une borne de sortie produit un signal sinusoïdal de fréquence et d'intensité prédéterminées telles que l'intensité du courant électrique généré par le générateur est calculée pour éviter de produire des rayonnements parasites sur les fils de connexion du générateur jusqu'à la bobine tout en étant suffisante pour avoir un effet sensible sur la détection de l'état électrique de l'électro-aimant, et la fréquence de fonctionnement du générateur est calculée d'une part pour entraîner des vibrations sur l'électro-aimant à des fréquences supérieures aux fréquences audibles, et d'autre part, pour entraîner des parasitages de fréquences inférieures à des fréquences de parasitage sensibles pour l'électronique environnante.

Selon un aspect de l'invention, l'électro-aimant n'est pas alimenté lors de la détection de défaut d'état électrique de sa bobine.

Selon un aspect de l'invention, le second moyen comporte un générateur de courant dont une borne de sortie est connectée à une première borne d'une impédance de référence présentant une valeur de référence $Z_{ref}$ dont l'autre borne est elle-même connectée à la masse électrique ; le générateur de courant électrique produit un signal en courant d'intensité et fréquence corrélées au générateur de courant dudit premier moyen; et les caractéristiques courant - tension ou en impédance du second moyen sont déterminées par l'impédance de la bobine de l'électro-aimant et par l'intensité et la fréquence du courant que lui fournit le premier moyen.

Selon un aspect de l'invention, le troisième moyen comporte un comparateur dont les bornes d'entrée sont connectées à des premier et second détecteurs de valeur de crête dont les bornes d'entrée sont respectivement connectées aux premier et second moyens. Une borne de sortie du comparateur est connectée à un moyen d'indication d'un défaut de l'électroaimant.

Selon un aspect de l'invention, le moyen d'indication d'un défaut de l'électro-aimant comporte une porte logique dont une première borne d'entrée est connectée à la borne de sortie du comparateur et dont une seconde borne est une borne d'entrée inverseuse qui est connectée à la masse électrique du circuit par l'intermédiaire d'une résistance électrique et à la borne d'alimentation positive en aval du dispositif de commande, de sorte que l'état de sortie du comparateur n'est pris en compte par le moyen d'indication que lorsque l'électro-aimant n'est pas alimenté par la batterie.

Selon un aspect de l'invention, une borne de sortie de la porte logique est connectée à l'entrée d'un dispositif d'alarme comme une lampe indicatrice d'un état de défaut de l'électroaimant.

Selon un aspect de l'invention, le moyen d'indication d'un défaut de l'électro-aimant coopère avec un moyen pour produire un ordre de commande transmis au dispositif de commande de façon à réitérer la commande pour faire passer une partie mobile de l'électro-aimant à la position attendue.

Selon un aspect de l'invention, le moyen d'indication d'un défaut de l'électro-aimant coopère avec un moyen permettant d'appliquer une correction à la position d'une partie mobile de l'électro-aimant.

Selon un aspect de l'invention, au moins l'un des premier ou second détecteurs de crête comporte une cellule pour filtrer la composante continue du signal d'entrée.

Selon un aspect de l'invention, les valeurs R de la résistance et C du condensateur de la cellule de détection de crête sont telles que le produit RxC est beaucoup plus grand que la valeur de $\frac{1}{f}$ où f est la fréquence du générateur de courant.

Selon un aspect de l'invention, les composants des premier et second détecteurs de crête sont choisis de sorte que la valeur R de la résistance et la valeur Re de la résistance de la cellule de suppression de la composante continue de chacun des détecteurs de crête soient telles que R soit très supérieure à une valeur de référence $Z_{ref}$ et Re très supérieure à une valeur de référence $Z_{ref}$ et $\frac{1}{(2\pi \times f \times Ce)}$ soit très inférieure à une valeur de référence $Z_{ref}$ où $Z_{ref}$ est une valeur représentative de l'impédance de référence du second moyen, $C_e$ est la valeur du condensateur de la cellule de suppression de la composante continue du détecteur de crête.

Selon un aspect de l'invention, la corrélation entre les générateurs de courant des premier et second moyens est réalisée à l'aide d'un unique générateur de courant du type comportant un oscillateur à référence de fréquence comme un quartz et d'un miroir de courant. La source de courant est connectée à une première borne d'un circuit miroir de courant dont une autre borne est connectée à la ligne d'alimentation positive, une borne de connexion du miroir de courant est connectée à la borne d'alimentation positive par l'intermédiaire d'une résistance servant de valeur de référence $Z_{ref}$. Deux dérivations partant des bornes c et d du circuit miroir de courant sont respectivement connectées à l'entrée du second détecteur de crête et à l'électro-aimant.

Selon un aspect de l'invention, la valeur de référence $Z_{ref}$ est prise égale à la valeur moyenne du module de l'impédance de la bobine de l'électro-aimant dans chacun des états.

Selon un aspect de l'invention, le second moyen comporte un moyen pour synthétiser une constante de circuit associée à au moins un état électrique dans lequel devrait se trouver la bobine de l'électro-aimant.

Selon un aspect de l'invention, le second moyen comporte une résistance connectée à une borne d'entrée d'un miroir de courant qui est aussi connectée à une chaîne de synthèse d'une constante de circuit qui comporte en série une cellule de filtrage de la composante continue, un amplificateur suiveur, une cellule de filtrage passe-bande et une cellule d'amplification de tension, une entrée a du circuit miroir de courant étant connectée à un générateur de courant de fréquence et intensité prédéterminées.

Selon un aspect de l'invention, le troisième moyen, avec les notations R : valeur de la résistance connectée à une borne d'entrée du miroir de courant, R' : valeur de la résistance de la cellule de filtrage passe-bande, R" : valeur de la résistance de rétroaction de la cellule d'amplification de tension, C : capacité du condensateur de la cellule de filtrage passe-bande, compare un terme indicatif jL(2πf) mesuré par le premier moyen à une constante de circuit jR"RC synthétisée par la chaîne de synthèse du second moyen soit encore L au produit R"xRxC, si on a $\frac{R'' \times R}{R'} = R_e$, où Re est la valeur de la résistance de la cellule de filtrage de la composante continue de la chaîne de synthèse d'une constante circuit.

Selon un aspect de l'invention, le réglage du montage se fait par une adaptation de la valeur de la résistance de la rétroaction de la cellule d'amplification de tension.

Selon un aspect de l'invention, le premier moyen comporte aussi un moyen de mesure de la tension aux bornes de l'électroaimant qui se dispose à la place du détecteur de crête connecté avec la borne de l'électro-aimant, une résistance placée en série avec la borne étant connectée à un interrupteur analogique bidirectionnel dont l'électrode de commande est commandée par un générateur de signal carré de même fréquence f que le générateur de courant et en quadrature par rapport à cette fréquence ; en ce que la borne commune de l'interrupteur analogique bidirectionnel et de la résistance est connectée à une borne d'entrée de filtre passe-bas dont la borne de sortie est connectée à une première borne d'entrée du comparateur du troisième moyen.

D'autres avantages et caractéristiques de la présente invention seront mieux compris à l'aide des dessins annexés :

- la figure 1 qui illustre un schéma bloc d'un dispositif de détection selon un mode de réalisation de l'invention :

    - la figure 2 qui illustre un schéma d'un électro-aimant équipé d'un élément mobile et connecté à un dispositif de commande ;

- la figure 3 qui illustre un schéma électrique représentatif de la bobine de l'électro-aimant de la figure 2 ;
- la figure 4 qui illustre un schéma électrique d'un composant du dispositif de détection de la figure 1 ;
- la figure 5 qui illustre un schéma bloc d'un mode de réalisation d'une partie du dispositif de détection de la figure 1 ;
- la figure 6 qui illustre un schéma bloc d'un autre mode de réalisation d'une partie du dispositif de détection représenté à la figure 1 ;
- la figure 7 qui illustre un schéma bloc d'une partie d'un circuit électronique destiné à compléter le schéma de la figure 6.

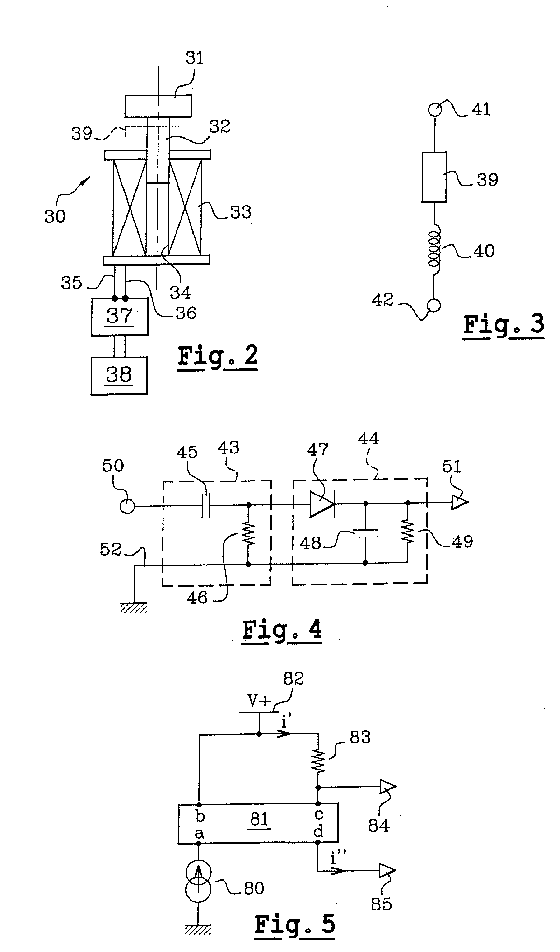

A la figure 2, on a représenté un schéma des éléments essentiels d'un électro-aimant dont l'état sera contrôlé par le dispositif de détection de l'invention.

L'électro-aimant 30 comporte, comme il est connu, une bobine 33, présentant un logement central 34 à l'intérieur duquel peut se déplacer un noyau en matériau magnétique, comme un noyau de fer 32, et qui entraîne un équipage mobile 31.

L'électro-aimant comporte aussi deux bornes 35 et 36 qui reçoivent un signal de tension d'activation produit par un dispositif de commande 37, connecté à une source d'énergie 38.

L'électro-aimant recevant un premier signal de tension, le noyau de fer 32 est déplacé pour passer en position 31. L'électroaimant recevant un second signal de tension, le noyau de fer 32 ramène l'équipage mobile dans la position en tirets 39.

Cependant, en particulier quand l'équipage mobile 31 est un cache pour un projecteur elliptique bi-fonctions, à cause de l'environnement, il se peut que le cache 31 ne redescende pas en position 39 malgré l'application du second signal de tension par le dispositif de commande 37.

A la figure 3, on a représenté le schéma électrique connu d'une bobine pour électro-aimant comme l'électro-aimant 30 de la figure 2.

La bobine 33 d'un électro-aimant 30 est essentiellement constituée d'une partie résistive 39 et d'une partie inductive 40 qui sont placées en série entre deux bornes 41 et 42. La partie résistive 39 représente la résistance électrique de la bobine 33, tandis que la partie inductive 40 représente à la fois la géométrie des spires de fils conducteurs constituant la bobine 33 ainsi que la perméabilité magnétique du noyau de fer magnétique 32 plongé dans le logement 34 de la bobine.

Si la bobine 33 est alimentée par un signal de type sinusoïdal, l'impédance de la bobine de l'électro-aimant vue du générateur sinusoïdal s'exprime en nombres complexes par :

$Z_{ea} = R_{ea} + jL_{ea}\omega$ dans laquelle $R_{ea}$ représente la valeur de la résistance 39 et $L_{ea}$ le coefficient d'inductance de la bobine 40.

Or, le coefficient $L_{ea}$ dépend de la géométrie de la bobine, du nombre de spires de fils qui la constitue ainsi que de la perméabilité magnétique du noyau de fer qui y est plongé. Il est donc clair que le coefficient $L_{ea}$ prend une première valeur $L_0$ quand le noyau de fer est entièrement plongé dans le logement 34, et une seconde valeur $L_1$ quand le noyau de fer est en position sortie 31.

De cette analyse, il résulte que la bobine doit présenter une première valeur $L_0$ dans un premier état électrique représentatif d'une première position d'une partie mobile de l'électro-aimant et une seconde valeur $L_1$ dans un second état électrique représentatif d'une seconde position d'une partie mobile de l'électro-aimant. Le principe de l'invention consiste donc à détecter que, alors qu'une commande dans une position déterminée d'une partie mobile de l'électroaimant a été effectuée, la bobine de l'électro-aimant n'est pas dans l'état électrique attendu.

Une telle méthode cependant n'est pas facilement utilisable lorsque la bobine est alimentée par une tension continue puisque seule la partie résistive serait détectable qui ne change pas.

Par ailleurs, l'utilisation d'une tension alternative nécessaire pour détecter la partie inductive applique une alternance de signaux de commande de la position du noyau et la bobine se mettant à vibrer mécaniquement peut produire un ronflement audible.

Enfin, l'application de signaux alternatifs produit un rayonnement parasite qui doit être contrôlé de façon à rester sous un seuil acceptable.

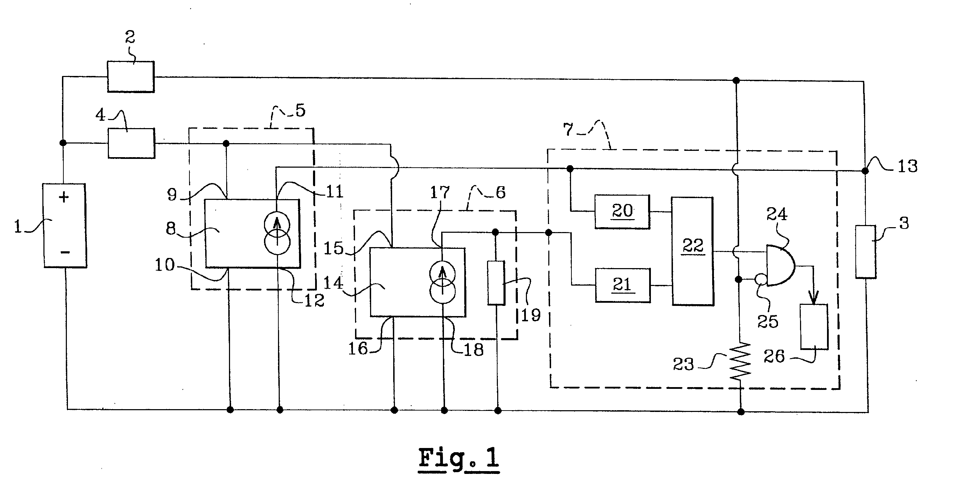

A la figure 1, on a représenté un schéma de principe d'un dispositif de détection selon l'invention appliqué à la commande d'un projecteur elliptique bi-fonctions (non représenté) équipé d'un cache mobilisé par l'électro-aimant contrôlé par le dispositif de l'invention. La référence 1 représente la batterie du véhicule. La borne positive de la batterie du véhicule est connectée à un commutateur de commande 2 dont une sortie est appliquée à une première borne de l'électro-aimant 3. Une seconde borne de l'électro-aimant est connectée à la masse commune avec la batterie 1.

Selon l'invention, le dispositif de détection est connecté directement à la borne positive de la batterie 1, optionnellement à travers un dispositif de protection 4, et comporte trois moyens principaux.

Dans un mode de réalisation, le dispositif de détection de l'invention fonctionne en permanence et il est associé à un électro-aimant unique comme l'actionneur du volet d'un projecteur bi-fonctions de véhicule automobile.

Dans un mode de réalisation, le dispositif de détection de l'invention travaille avec un électro-aimant qui est alimenté par une tension électrique découpée. Dans ce cas, le dispositif de détection exécute la détection de l'état de l'électro-aimant pendant la partie de temps où la tension d'alimentation est nulle.

Dans le mode de réalisation préféré, lorsque l'électroaimant 3 n'est pas alimenté lors de la détection de défaut d'état électrique de sa bobine, le premier moyen 5 comporte un générateur de courant 8 connecté par une borne 9 à la tension d'alimentation continue positive délivrée par la batterie 1 et par une borne 10 à la masse électrique.

Le générateur de courant 8 comporte ensuite une borne de sortie 11 d'un signal sinusoïdal de fréquence et d'intensité prédéterminées et une borne de sortie 12 du générateur de courant 8 est connectée à la masse.

L'intensité du courant électrique généré par le générateur 8 est calculée pour éviter de produire des rayonnements parasites sur les fils de connexion du générateur jusqu'à la bobine 3 tout en étant suffisante pour avoir un effet sensible sur la détection de l'état électrique de l'électro-aimant 3 auquel il est connecté par la borne de connexion 13.

La fréquence de fonctionnement du générateur 8 est calculée d'une part pour entraîner des vibrations sur l'électroaimant 3 à des fréquences supérieures aux fréquences audibles et pour entraîner des fréquences de parasitage inférieures à des fréquences de parasitage sensibles pour l'électronique environnante.

Le premier moyen 5 est donc, dans le mode de réalisation représenté, essentiellement un générateur de signal de test. Mais, il est naturellement un moyen pour produire un signal représentatif de l'état électrique de la bobine de l'électro-aimant. En effet, on a vu que l'impédance de la bobine était un nombre complexe $Z_{ea}$ et il en résulte que le fil reliant sa borne de sortie 11 à la borne 13 de l'électro-aimant est à un potentiel alternatif qui s'exprime par : $V_{11}$ = $i_{11}$ x $Z_{ea}$ où $i_{11}$ exprime le courant sinusoïdal généré par le générateur 8. Il en résulte que $V_{11}$ présente une amplitude et une phase dépendant de $Z_{ea}$ et donc du fait que la bobine se trouve dans un premier ou un second état électrique.

Le dispositif de détection de l'invention comporte ensuite un second moyen comportant lui aussi un générateur de courant 14 connecté entre ses bornes d'entrées 15 et 16 respectivement à la borne positive de la batterie 1, éventuellement à travers le dispositif optionnel de protection 4, et la borne 16 est connectée à la masse.

Les bornes de sortie du générateur de courant 14 sont respectivement connectées 18 à la masse et 17 à une première borne d'une impédance de référence 19 dont l'autre borne est elle-même connectée à la masse électrique.

Le générateur de courant électrique 14 produit un signal en courant d'intensité corrélée avec l'intensité du générateur de courant 8 et à une fréquence elle-même corrélée avec la fréquence du générateur 8. Le choix de cette corrélation est à la discrétion de l'homme de métier aidé de la présente description.

Le point commun à l'impédance 19 de référence et à la borne 17 du générateur 14 sert de borne de sortie au second moyen 6.

Le second moyen 6 constitue un élément de référence qui représente l'inductance ou l'effet équivalent de l'inductance de la bobine de l'électro-aimant dans l'état que l'on souhaite contrôler. Il produit donc dès que le dispositif de l'invention est activé, un second signal $v_{19}$ représentatif de l'état dans lequel devrait se trouver la bobine de l'électro-aimant 3.

En particulier, les caractéristiques courant - tension ou en impédance du second moyen 6 sont donc déterminées lors de la construction du dispositif de l'invention essentiellement par la valeur du terme inductif 40 de la bobine de l'électro-aimant 3 et par l'intensité et la fréquence du courant que lui injecte le premier moyen 5.

Les bornes de sortie des premier et second moyens 5 et 6 sont connectées respectivement aux entrées d'un troisième moyen 7 pour comparer les dits premier et second signaux et produire un signal représentatif d'un défaut de l'électro-aimant.

Dans un mode préféré de réalisation, le troisième moyen 7 est prévu pour comparer en amplitude et en phase les tensions $v_{11}$ et $v_{19}$ à ses bornes d'entrée. A cet effet, le troisième moyen 7 comporte un comparateur 22 dont une première borne est connectée à la sortie d'un premier détecteur 20 de valeur de crête dont l'entrée est connectée à la sortie du générateur de courant 8 du premier moyen 5.

Le détecteur de crête 20 mesure donc un signal représentatif de la tension instantanée aux bornes de l'électroaimant 3.

Une seconde borne d'entrée du comparateur 22 est connectée à la borne de sortie d'un détecteur de crête 21 dont la borne d'entrée est connectée à la borne de sortie du second moyen 6 produisant un signal de tension $v_{19}$ représentatif de l'état dans lequel se trouve l'inductance de référence 19.

Le comparateur 22 comporte une borne de sortie qui est connectée à un moyen d'indication d'un défaut de l'électro-aimant qui comporte une portée logique 24 dont une première borne d'entrée est connectée à la borne de sortie du comparateur 22 et dont une seconde borne 25 est une borne d'entrée inverseuse qui est connectée à la masse électrique du circuit par l'intermédiaire d'une résistance électrique 23 et à la borne d'alimentation positive en aval du dispositif de commande 2.

De ce fait, l'état de sortie du comparateur 22 n'est pris en compte par le dispositif indicateur que lorsque l'électro-aimant n'est pas alimenté par la batterie 1.

Une borne de sortie de la porte logique 24 est connectée à l'entrée d'un dispositif 26 qui, dans un premier mode de réalisation, est composée essentiellement d'une lampe indicatrice d'un défaut de l'électro-aimant 3. Cette lampe peut être installée sur le tableau de bord du véhicule sur lequel le projecteur bi-fonctions est installé.

Dans un autre mode de réalisation, le moyen d'indication d'un défaut de l'électro-aimant coopère avec un moyen pour produire un ordre de commande transmis au dispositif de commande 2 de façon à réitérer la commande pour faire passer la partie mobile de l'électro-aimant 3 à la position attendue.

Dans un autre mode de réalisation, le moyen d'indication d'un défaut de l'électro-aimant coopère avec un moyen permettant d'appliquer une correction à la position d'une partie mobile de l'électro-aimant 3.

On va maintenant décrire un mode de réalisation particulier du dispositif de la figure 1.

A la figure 4, on a représenté un mode de réalisation du détecteur de crête 20 ou 21 du troisième moyen 7 de la figure 1.

Préférentiellement, le détecteur de crête utile à l'invention comporte une cellule de détection de crête 44 qui comporte sur la ligne positive de signal une diode 47 dont la cathode est connectée à un circuit parallèle constitué d'un condensateur 48 et d'une résistance 49 dont l'autre borne commune est connectée à la masse électrique 52.

Le point commun de la cathode de la diode 47, de la résistance 48 et du condensateur 49 est connecté à l'une des bornes d'entrée du comparateur 22 du dispositif de détection 51.

Préférentiellement, le dispositif de détection de crête comporte aussi une cellule pour filtrer la composante continue du signal d'entrée.

La cellule 43 de filtrage de la composante du signal comporte un condensateur 45 connecté à une première borne d'une résistance électrique 46 dont l'autre borne est connectée à la masse et la borne commune du condensateur 45 et de la résistance 46 sont connectée à l'anode de la diode 47 de la cellule 44 de détection de la crête proprement dite.

Pour réaliser une élimination convenable de la composante continue d'une part, pour éviter de subir la dispersion des tolérances des composants des deux dispositifs de détection de crête 20 et 21 d'autre part, les valeurs R de la résistance 49 et C du condensateur 48 doivent être telles que le produit RxC soit beaucoup plus grand que la valeur de $\frac{1}{f}$ où f est la fréquence du générateur de courant 8.

Il faut par ailleurs à la fois que la valeur R de la résistance 49 et la valeur Re de la résistance 46 de la cellule de suppression de la composante continue 43 de chacun des détecteurs de crête 20 et 21 de la figure 2 soient telles que R soit très supérieure à une valeur de référence $Z_{ref}$ représentative de l'impédance de référence 19 que Re soit très supérieure à $Z_{ref}$ et que $\frac{1}{(2\pi \times f \times Ce)}$ soit très inférieure à $Z_{ref}$ où $C_e$ est la valeur du condensateur 46 de la cellule de suppression de la composante continue 43 du détecteur de crête 20 et 21.

Les expressions « très inférieure » ou « très supérieure » doivent être comprises comme signifiant que le rapport entre les deux grandeurs comparées est au moins égal à dix et préférentiellement au moins égal à 100.

Grâce à cette sélection de valeurs de résistance et capacité des deux détecteurs de crête, on évite d'être soumis à la condition d'égalité des valeurs des résistances 49 et 46 pour les détecteurs de crête 20 et 21.

A la figure 5, on a représenté un mode de réalisation du dispositif de détection de la figure 1 dans lequel l'inductance est simulée par une résistance 83 et dans lequel la corrélation entre les générateurs de courant 8 et 14 est réalisée à l'aide d'un unique générateur de courant 80 et d'un miroir de courant 81.

Dans un mode de réalisation, la source de courant 80 est constituée par un oscillateur sinusoïdal de tension et de fréquences déterminées comme indiqué plus haut. La source de courant 80 est connectée à une première borne a d'un circuit 81 miroir de courant dont une autre borne b est connectée à la ligne d'alimentation positive 82 connectée à la batterie 1. Une borne de connexion c du miroir de courant 81 est connectée, elle aussi, à la borne d'alimentation positive 82 par l'intermédiaire d'une résistance de référence 83. Les deux dérivations 84 et 85 sont respectivement connectées respectivement à l'entrée de détecteur de crête 21 et à l'électro-aimant 3 de la figure 1.

Pour obtenir le fonctionnement souhaité, il suffit que i'-i'' soit très inférieur à i' ce qui est toujours assuré dans les schémas classiques de miroir de courant.

La condition i' = i n'est pas impérative puisque c'est le respect de cette condition que perturbe la dispersion des composants du miroir.

La partie alternative de la tension de sortie est alors :

$$-Z_{ref} \times i' = -Z_{ref} \times i''$$

Dans un mode particulier de réalisation, la valeur $Z_{ref}$ est prise égale à la valeur moyenne du module de l'impédance de la bobine de l'électro-aimant 3 dans chacun des états. Pour l'application au projecteur elliptique bi-fonctions, on aura :

$$Z_{ref} = \frac{1}{2}\left(\sqrt{R_{ea}^2 + (2\pi f L_0)^2} + \sqrt{R_{ea}^2 + (2\pi f L_1)^2}\right)$$

Comme décrit à l'aide de la figure 2, l'électro-aimant 3 prenant deux positions, il présente une résistance constante $R_{ea}$ et une inductance $L_0$ et $L_1$ selon la position 31 ou 39 (figure 4) de l'élément mobile.

Un avantage de la solution représentée à l'aide de la figure 5 est de permettre de n'avoir qu'un seul composant de référence qui est peu coûteux et qui peut être ajusté en série.

Cependant, on remarque que la valeur $Z_{ref}$ dépend de la fréquence, ce qui exige un oscillateur précis et stable qui peut être constitué autour d'un oscillateur à quartz.

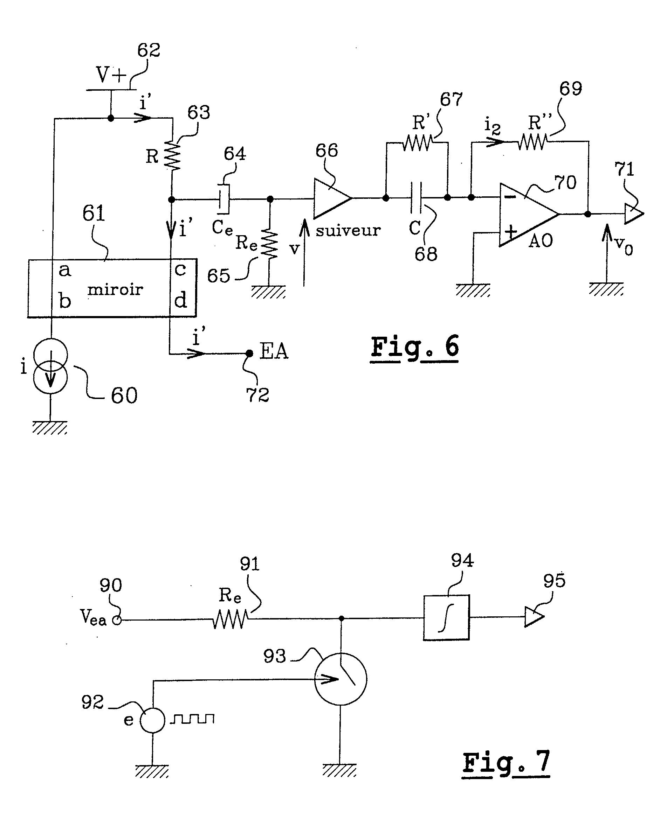

A la figure 6, on a représenté un autre mode de réalisation permettant d'éviter un oscillateur à quartz.

Le principe de la solution présentée à l'aide de la figure 6 est de comparer le terme inductif 40 de la bobine de l'électroaimant 3 à une constante du circuit de référence qui ne dépend plus alors de la fréquence. A cet effet, le dispositif de l'invention comporte un moyen pour générer une constante de circuit associée à au moins l'un des états attendus dans lesquels devraient se trouver la bobine 3 de l'électro-aimant, à cause de la position dans laquelle se trouve la partie mobile de l'électroaimant, c'est-à-dire aussi la position dans laquelle se trouve son noyau ferromagnétique qui influe sur cet état électrique.

A la figure 6, on a repris le schéma de base de la figure 5 dans lequel est disposé un miroir de courant 61 connecté à un oscillateur sinusoïdal 60 et à une borne positive de tension continue 62.

Une borne a du miroir de courant 61 est aussi connectée à l'alimentation positive continue 62 par l'intermédiaire d'une résistance 63 de valeur R. Une borne b du miroir de courant 61 est connectée à un générateur sinusoïdal de courant 60, de fréquence et d'intensité prédéterminées.

La résistance 63 est aussi connectée à une chaîne de synthèse d'une constante de circuit qui comporte une cellule 64, 65 de filtrage de la composante continue, 66 d'un amplificateur suiveur 67, 68 de filtrage passe-bande et 69, 70 d'amplification de tension.

La cellule 64, 65 comporte un condensateur 64 de valeur Ce et une résistance Re 65 connectée à la masse.

Le point commun du condensateur 64 et de la résistance 65 est connectée à la borne d'entrée de l'amplificateur suiveur 66.

La cellule de filtrage passe-bande 67, 68 comporte une résistance de la valeur R' 67 connectée en parallèle à un condensateur 68 de valeur C.

L'amplificateur 70 comporte une borne d'entrée - qui est rétroagie par la borne de sortie de l'amplificateur 70 par l'intermédiaire d'une résistance 69 de valeur R". La borne d'entrée + de l'amplificateur 70 est connectée à la masse. La borne de sortie de l'amplificateur 70 est à une tension $v_0$ audessus de la masse électrique qui est transmise par sa borne 71 au dispositif détecteur de crête 21 sur le schéma de la figure 2. Avec les notations v : tension à l'entrée de l'amplificateur suiveur 66, i : courant produit par l'oscillateur 60, i' : courant issu de la borne 72 et traversant la bobine, R valeur de la résistance 63, R' : valeur de la résistance 67 et R" : valeur de la résistance 69, C : capacité du condensateur 68, il vient :

$$v = -Ri'$$

$$i_2 = \frac{V}{R'} + C \times \frac{dV}{dt}$$

$$V_0 = -R'' \times i_2 = \frac{R'' \times R}{R'} \times i' + R'' \times R \times C \times \frac{di'}{dt}$$

Aux bornes de l'électro-aimant, on a $v_{ea} = R_{ea} \times i' + L \times \frac{di'}{dt}$ (L=L$_0$ ou L$_1$)

Si on a $\frac{R'' \times R}{R'} = R_e$, le circuit complet compare le terme inductif jL(2πf) de la bobine 3 à jR"RC(2πf) constante de circuit produite par la chaîne de synthèse 63-71 du second moyen, soit encore L à R"RC, ce dernier terme ne variant pas avec f, fréquence de la source de tension 60.

Le schéma de la figure 6 présente l'avantage de ne pas dépendre de la fréquence du générateur de courant 60 qui peut être constitué sur la base d'un circuit intégré classique sans référence d'horloge comme un circuit LM555.

Le circuit de la figure 6 présente cependant l'inconvénient de comporter trois composants dont les variations de valeur, lors d'une mise en production en série, peuvent présenter des problèmes. Il s'agit des composants résistifs 63 de valeur R et 69 de valeur R" ainsi que du condensateur 68 de valeur C.

Grâce au gain d'amplificateur du montage 69, 70, selon l'invention, le réglage du montage se fait par une adaptation de la valeur de la résistance 69 et ici ajustable lors de la production du dispositif de détection de l'invention.

A la figure 7, on a représenté un mode de réalisation d'un moyen de mesure de la tension aux bornes de l'électro-aimant qui se dispose à la place du détecteur de crête 20. Dans ce circuit, la borne 90 est connectée avec la borne 13 du montage de la figure 1. Une résistance 91 est placée en série avec la borne 90 et son autre borne est connectée à un interrupteur analogique bidirectionnel 93 dont l'électrode de commande est commandée par un générateur 92 de signal carré de même fréquence f que le générateur de courant 60 ou 80 des figures 5 et 6 et en quadrature avance ou retard par rapport à cette fréquence.

La borne commune de l'interrupteur analogique bidirectionnel 93 et de la résistance 91 est connectée à une borne d'entrée d'un module de calcul de la valeur moyenne au cours du temps du signal de sortie de l'interrupteur analogique 91. Dans un mode de réalisation préféré, le module de calcul de la valeur moyenne est un filtre passe-bas 94 constituée par un amplificateur intégrateur dont la borne de sortie 95 est connectée à une première borne d'entrée du comparateur du troisième moyen 7 du dispositif de détection de la figure 1. On note qu'il est essentiel que les deux signaux appliqués aux entrées du comparateur 22 du moyen 7 soient en quadrature pour assurer une détection correcte de l'état de l'électro-aimant.

La tension relativement à la masse électrique établie à la borne 95 est proportionnelle au produit $L\omega i'$ où i' est le courant traversant l'électro-aimant.

Dans un mode de réalisation pratique, on a choisi une fréquence de fonctionnement du schéma à 37 Kilos Hertz.

Selon l'invention, le dispositif de détection peut être adapté pour détecter plusieurs états de l'électro-aimant 3 s'il dispose de plusieurs positions, en particulier, le dispositif peut être augmenté à l'aide d'un comparateur multiplexé, le moyen 6 étant répété pour chacun des états que l'on souhaite détecter.

## Revendications

1. Dispositif de détection de l'état d'un électro-aimant, l'électro-aimant pouvant prendre au moins deux états sous l'effet d'un signal de commande, **caractérisé en ce qu'**il comporte :

   - un premier moyen (5) pour produire un premier signal représentatif de l'état instantané de la bobine (3) de l'électroaimant ;
   - un second moyen (6) pour produire un second signal représentatif de l'état dans lequel devrait se trouver la bobine (3) de l'électro-aimant ;
   - un troisième moyen (7) pour comparer les dits premier et second signaux et produire un signal représentatif d'un défaut de l'électro-aimant (3).

2. Dispositif selon la revendication 1, **caractérisé en ce que** le premier moyen (5) comporte un générateur de courant (8) connecté par une borne (9) à la tension d'alimentation continue positive fournie par la batterie (1) et par une borne (10) à la masse électrique, dont une borne de sortie (11) produit un signal sinusoïdal de fréquence et d'intensité prédéterminées telles que l'intensité du courant électrique généré par le générateur (8) est calculée pour éviter de produire des rayonnements parasites sur les fils de connexion du générateur jusqu'à la bobine (3) tout en étant suffisante pour avoir un effet sensible sur la détection de l'état électrique de l'électro-aimant (3) et la fréquence de fonctionnement du générateur (8) est calculée d'une part pour entraîner des vibrations sur l'électro-aimant (3) à des fréquences supérieures aux fréquences audibles et d'autre part pour entraîner des parasitages de fréquences inférieures à des fréquences de parasitage sensibles pour l'électronique environnante.

3. Dispositif selon la revendication 2, **caractérisé en ce que** l'électro-aimant (3) n'est pas alimenté lors de la détection de défaut de l'électro-aimant.

4. Dispositif selon la revendication 2 ou 3, **caractérisé en ce que** le second moyen (7) comporte un générateur de courant (14) dont une borne de sortie (17) est connectée à une première borne d'une impédance de référence (19) présentant une valeur de référence $Z_{ref}$ dont l'autre borne est elle-même connectée à la masse électrique ; **en ce que** le générateur de courant électrique (14) produit un signal en courant d'intensité et fréquence corrélées au générateur de courant (8) dudit premier moyen (5); et **en ce que** les caractéristiques courant - tension ou en impédance du second moyen (6) sont déterminées par l'impédance de la bobine de l'électro-aimant (3) et par l'intensité et la fréquence du courant que lui fournit le premier moyen (5).

5. Dispositif selon la revendication 1, **caractérisé en ce que** le troisième moyen (7) comporte un comparateur (22) dont les bornes d'entrée sont connectées à des premier (20) et second (21) détecteurs de valeur de crête dont les bornes d'entrée sont respectivement connectées aux premier (5) et second (6) moyens et **en ce qu'**une borne de sortie du comparateur (22) est connectée à un moyen (23 - 26) d'indication d'un défaut de l'électro-aimant (3).

6. Dispositif selon la revendication 5, **caractérisé en ce que** le moyen d'indication d'un défaut de l'électro-aimant (3) comporte une porte logique (24) dont une première borne d'entrée est connectée à la borne de sortie du comparateur (22) et dont une seconde borne (25) est une borne d'entrée inverseuse qui est connectée à la masse électrique du circuit par l'intermédiaire d'une résistance électrique (23) et à la borne d'alimentation positive en aval du dispositif de commande (2), de sorte que l'état de sortie du comparateur (22) n'est pris en compte par le moyen d'indication (23, 26) que lorsque l'électro-aimant n'est pas alimenté par la batterie (1).

7. Dispositif selon la revendication 6, **caractérisé en ce que** une borne de sortie de la porte logique (24) est connectée à l'entrée d'un dispositif d'alarme (26) comme une lampe indicatrice d'un défaut de l'électro-aimant (3).

8. Dispositif selon la revendication 6 ou 7, **caractérisé en ce que** le moyen d'indication d'un défaut de l'électro-aimant (3) coopère avec un moyen pour produire un ordre de commande transmis au dispositif de commande (2) de façon à réitérer la commande pour faire passer une partie mobile de l'électro-aimant (3) à la position attendue.

9. Dispositif selon la revendication 8, **caractérisé en ce que** le moyen d'indication d'un défaut de l'électro-aimant (3) coopère avec un moyen permettant d'appliquer une correction à la position d'une partie mobile de l'électro-aimant (3).

10. Dispositif selon la revendication 5, **caractérisé en ce qu'**au moins l'un des premier (20) ou second (21) détecteur de crête comporte une cellule (43) pour filtrer la composante continue du signal d'entrée.

11. Dispositif selon la revendication 10, **caractérisé en ce que** les valeurs R de la résistance (49) et C du condensateur (48) de la cellule (44) de détection de la crête (20, 21) sont telles que le produit RxC est beaucoup plus grand que la valeur de $\frac{1}{f}$ où f est la fréquence du générateur de courant (8).

12. Dispositif selon les revendications 10 et 11,
    **caractérisé en ce que** les composants des premier et second détecteurs de crête (20, 21) sont choisis de sorte que la valeur R de la résistance (49) et la valeur (Re) de la résistance (46) de la cellule de suppression de la composante continue (43) de chacun des détecteurs de crête (20, 21) soient telles que R soit très supérieure à une valeur de référencé $Z_{ref}$ et Re très supérieure à une valeur de référence $Z_{ref}$ et $\frac{1}{(2\pi \times f \times Ce)}$ soit très inférieure à une valeur de référence $Z_{ref}$ où $Z_{ref}$ est une valeur représentative de l'impédance de référence (19) du second moyen (6), $C_e$ est la valeur du condensateur (46) de la cellule de suppression de la composante continue (43) du détecteur de crête (20, 21).

13. Dispositif selon la revendication 2 ou 3, **caractérisé en ce que** la corrélation entre les générateurs de courant (8, 14) des premier et second moyens (5, 6) est réalisée à l'aide d'un unique générateur de courant (80) du type comportant un oscillateur à référence de fréquence comme un quartz et d'un miroir de courant (81); et **en ce que** la source de courant (80) est connectée à une première borne (a) du circuit (81) miroir de courant dont une autre borne (b) est connectée à une ligne d'alimentation positive (82), une borne de connexion (c) du miroir de courant (81) est connectée à la ligne d'alimentation positive (82) par l'intermédiaire d'une résistance servant de valeur $Z_{ref}$ de référence (83) simulant le terme inductif (40) de la bobine de l'électroaimant au moins dans un état attendu de celle-ci correspondant à au moins une position de sa partie mobile; et **en ce que** deux dérivations (84, 85) portant des bornes (c) et (d) du circuit miroir de courant (81) sont respectivement connectées à l'entrée du second détecteur de crête (21) et à l'électro-aimant (3).

14. Dispositif selon l'une des revendications 12 ou 13,
    **caractérisé en ce que** la valeur de référence $Z_{ref}$ est prise égale à la valeur moyenne du module de l'impédance de la bobine de l'électro-aimant (3) dans chacun des états.

15. Dispositif selon la revendication 2 ou 3, **caractérisé en ce que** le second moyen (7) comporte un moyen pour synthétiser une constante de circuit associée à au moins un état électrique dans lequel devrait se trouver la bobine de l'électro-aimant (3).

16. Dispositif selon la revendication 15, **caractérisé en ce que** le second moyen (6) comporte une résistance (63) connectée à une borne d'entrée (c) d'un miroir de courant (61) qui est aussi connectée à une chaîne de synthèse d'une constante de circuit qui comporte en série une cellule (64, 65) de filtrage de la composante continue, un amplificateur suiveur (66), une cellule de filtrage passe-bande (67, 68) et une cellule d'amplification de tension (69, 70), une entrée (a) du circuit miroir de courant (61) étant connectée à un générateur de courant (60) de fréquence et intensité prédéterminées.

**17.** Dispositif selon la revendication 16, **caractérisé en ce que** le troisième moyen (7), avec les notations R valeur de la résistance (63) connectée à une borne d'entrée (a) du miroir de courant (61), R' : valeur de la résistance (67) de la cellule de filtrage passe-bande, R" : valeur de la résistance (69) de rétroaction de la cellule d'amplification de tension, C : capacité du condensateur (68) de la cellule de filtrage passe-bande, compare un terme inductif jL (2πf) mesuré par le premier moyen (5) à une constante de circuit jR"RC(2πf) synthétisée par la chaîne de synthèse du second moyen (6) soit encore L au produit R"RC, si on a $\frac{R'' \times R}{R'} = R_e$, où Re est la valeur de la résistance (65) de la cellule de filtrage de la composante continue (64, 65) de la chaîne de synthèse d'une constante de circuit.

**18.** Dispositif selon la revendication 16, **caractérisé en ce que** le réglage de la chaîne de synthèse (63-71) se fait par une adaptation de la valeur de la résistance (69) de la rétroaction d'amplification de la cellule de l'amplificateur (69, 70) de tension.

**19.** Dispositif selon la revendication 2, **caractérisé en ce que** le premier moyen (5) comporte aussi un moyen de mesure de la tension aux bornes de l'électro-aimant qui se dispose à la place du détecteur de crête (20) connecté (90) avec la borne (13) de l'électro-aimant, une résistance (91) placée en série avec la borne (90) étant connectée à un interrupteur analogique bidirectionnel (93) dont l'électrode de commande est commandée par un générateur (92) de signal carré de même fréquence f que le générateur de courant (60 ; 80) et en quadrature par rapport à cette fréquence ; **en ce que** la borne commune de l'interrupteur analogique bidirectionnel (93) et de la résistance (91) est connectée à une borne d'entrée de filtre passe-bas (94) dont la borne de sortie (95) est connectée à une première borne d'entrée du comparateur du troisième moyen (7).

**Fig. 1**

31

39 32

30 33

35 34
37 36
38

**Fig. 2**

41

39

40

42 **Fig. 3**

50 45 43 47 44 51

52 48 49

46

**Fig. 4**

82

V+ i'

83

b 81 c 84

a d
i''

80 85

**Fig. 5**

EP 1 262 785 A1

**Fig. 6**

**Fig. 7**

13

EP 1 262 785 A1

**Office européen des brevets**

**RAPPORT DE RECHERCHE EUROPEENNE**

Numéro de la demande

EP 02 29 1289

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 316 493 A (NORMAND EQUIP IND) 24 mai 1989 (1989-05-24) * colonne 3, ligne 22 - ligne 53 * * colonne 4, ligne 11 - colonne 5, ligne 13 * * revendications 1,5; figure 2 * | 1-19 | G01R33/02 |
| A | DE 44 30 867 A (LICENTIA GMBH) 7 mars 1996 (1996-03-07) * colonne 1, ligne 67 - colonne 2, ligne 10 * * colonne 2, ligne 41 - colonne 3, ligne 22 * * figure 1 * | 1-10 | |
| A | JP 62 091357 A (TOSHIBA CORP) 25 avril 1987 (1987-04-25) * abrégé * | 1 | |

**DOMAINES TECHNIQUES RECHERCHES (Int.Cl.7)**

G01R

Le présent rapport a été établi pour toutes les revendications

| Lieu de la recherche | Date d'achèvement de la recherche | Examinateur |
|---|---|---|
| LA HAYE | 20 septembre 2002 | Schneiderbauer, K |

**ANNEXE AU RAPPORT DE RECHERCHE EUROPEENNE
RELATIF A LA DEMANDE DE BREVET EUROPEEN NO.**

EP 02 29 1289

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-09-2002

| Document brevet cité au rapport de recherche | | Date de publication | Membre(s) de la famille de brevet(s) | | Date de publication |
|---|---|---|---|---|---|
| EP 0316493 | A | 24-05-1989 | EP | 0316493 A1 | 24-05-1989 |
|  |  |  | AT | 54031 T | 15-07-1990 |
|  |  |  | DE | 3763346 D1 | 26-07-1990 |
| DE 4430867 | A | 07-03-1996 | DE | 4430867 A1 | 07-03-1996 |
|  |  |  | FR | 2724045 A1 | 01-03-1996 |
|  |  |  | US | 5673165 A | 30-09-1997 |
| JP 62091357 | A | 25-04-1987 | JP | 1690455 C | 27-08-1992 |
|  |  |  | JP | 3055342 B | 23-08-1991 |

EPO FORM P0460

Pour tout renseignement concernant cette annexe : voir Journal Officiel de l'Office européen des brevets, No.12/82